# EUROPEAN PATENT APPLICATION

(11) **EP 4 535 435 A1**
(43) Date of publication of application: **09.04.2025**
(21) Application number: 23834385.9
(22) Date of filing: 01.03.2023
(51) Int. Cl.: H01L 31/18, H01L 31/20, C23C 14/08, C23C 14/14, C23C 14/35, C23C 14/50

(54) **SOLAR CELL PREPARATION METHOD, AND COATING CARRIER PLATE FOR SOLAR CELL AND APPLICATION THEREOF**

(30) Priority: 07.07.2022 CN 202210796044
(71) Applicant: Tongwei Solar (Chengdu) Co., Ltd., Chengdu, Sichuan 610299 (CN)
(72) Inventor: XUE, Jianfeng, Chengdu, Sichuan 610299 (CN); WANG, Yongjie, Chengdu, Sichuan 610299 (CN); YU, Yi, Chengdu, Sichuan 610299 (CN); SU, Shijie, Chengdu, Sichuan 610299 (CN)
(74) Representative: Gill Jennings & Every LLP
(86) International application number: PCT/CN2023/078927
(87) International publication number: WO 2024/007601

(57) **Abstract**

The present disclosure discloses a solar cell preparation method, including the following steps: providing a coating carrier plate; and placing, on the coating carrier plate, a wafter to be prepared into the solar cell, and depositing a transparent conductive film on a surface of the wafter, wherein a method for preparing the coating carrier plate include: depositing a metal layer on a carrier plate substrate, and then oxidizing the metal layer to form a first metal oxide layer on the metal layer.

## Description

### CROSS-REFERENCE TO RELATED APPLICATIONS

This application claims priority to Chinese Patent Application No. 2022107960444, entitled "SOLAR CELL PREPARATION METHOD, AND COATING CARRIER PLATE FOR SOLAR CELL AND APPLICATION THEREOF", filed on July 7, 2022, the content of which is incorporated herein by reference in its entirety.

### TECHNICAL FIELD

The present disclosure relates to the technical field of solar cells, particularly to a preparation method of a solar cell, as well a coating carrier plate for a solar cell and an application thereof.

### BACKGROUND

A solar cell is a device that can convert solar energy into electrical energy. As the solar energy is an inexhaustible source of clean energy, the solar cell has high commercial value and broad application prospect.

Heterojunction cell is a specific type of solar cell. The manufacturing process of the heterojunction cell includes: first, an N-type monocrystalline silicon wafer is textured and cleaned; next, an intrinsic amorphous silicon film and an N-type amorphous silicon film are deposited on a front-side of the silicon wafer, and an intrinsic amorphous silicon film and a P-type amorphous silicon film are deposited on a back-side of the silicon wafer; then, a transparent conductive film is coated on the amorphous silicon; and finally, a grid line electrode is prepared on the transparent conductive film. The transparent conductive film can play a crucial role in collecting and transmitting current while also providing an anti-reflective property. Therefore, the photoelectric properties of the transparent conductive film directly affect the specific performance of the solar cell, particularly the fill factor of the solar cell.

The transparent conductive film is usually prepared by a coating process. During the manufacturing process of the heterojunction solar cell, a coating carrier plate is often used to support the solar cell. When depositing the transparent conductive film such as ITO, some material of the transparent conductive film material would be deposited on the surface of the coating carrier plate. Once the material reaches a certain thickness, the carrier plate must be cleaned to remove the deposited material of the transparent conductive film for subsequent use. However, it has been found in the actual manufacturing process that when the coating carrier plate is used for the first time or re-used after cleaning the deposited material from its surface, the resulting solar cells exhibit a surface sheet resistance that is higher initially and gradually decreases and eventually stabilizes as the number of coating applications increases. This stabilization process takes a long time, during which the sheet resistance of the solar cells is gradually changed, which is not conducive to controlling the stability of the product quality.

### SUMMARY

According to some embodiments of the present disclosure, a preparation method of a solar cell is provided, which includes the following steps:
providing a coating carrier plate; and
placing, on the coating carrier plate, a wafer to be prepared into the solar cell, and depositing a transparent conductive film on a surface of the wafer.

A preparation method of the coating carrier plate includes:
depositing a metal layer on a carrier plate substrate, and then subjecting the metal layer to an oxidation treatment to form a first metal oxide layer on the metal layer.

In some embodiments of the present disclosure, the step of the subjecting the metal layer to the oxidation treatment includes: placing the carrier plate substrate deposited with the metal layer in a first humid environment to absorb moisture and oxidizing the metal layer by the moisture.

In some embodiments of the present disclosure, a humidity of the first humid environment is controlled to be 30% to 50%, and a temperature of the first humid environment is controlled to be 20°C to 25°C.

In some embodiments of the present disclosure, the preparation method further includes: prior to depositing the metal layer, placing the carrier plate substrate in an environment containing an oxidizing substance to adhere the oxidizing substance to a surface of the carrier plate substrate, and forming a second metal oxide layer on a surface of the subsequently deposited metal layer adjacent to the carrier plate substrate under an action of the adhered oxidizing substance.

In some embodiments of the present disclosure, placing the carrier plate substrate in the environment containing the oxidizing substance includes: placing the carrier plate substrate in a second humid environment to absorb moisture as the oxidizing substance.

In some embodiments of the present disclosure, a humidity of the second humid environment is controlled to be 30% to 50%, and a temperature of the second humid environment is controlled to be 20°C to 25°C.

In some embodiments of the present disclosure, the carrier plate substrate is placed in the second humid environment for a time of 6 hours to 12 hours.

In some embodiments of the present disclosure, the preparation method of the coating carrier plate further includes: depositing a first transparent conductive film layer on the first metal oxide layer.

In some embodiments of the present disclosure, when depositing the first transparent conductive film layer, an indium tin oxide target is used as a target, and oxygen is introduced at a flow rate of 50 sccm to 100 sccm during deposition.

In some embodiments of the present disclosure, the preparation method of the coating carrier plate further includes: depositing a second transparent conductive film layer on the carrier plate substrate prior to depositing the metal layer.

In some embodiments of the present disclosure, when depositing the second transparent conductive film layer, an indium tin oxide target is used as a target, and oxygen is introduced at a flow of 50 sccm to 100 sccm during deposition.

In some embodiments of the present disclosure, the metal layer is deposited by magnetron sputtering, and when depositing the metal layer, a sputtering power is controlled to be 8.5 kW to 13.5 kW, and a deposition temperature is controlled to be 120°C to 150°C.

According to some other embodiments of the present disclosure, a coating carrier plate for a solar cell is provided, which includes: a carrier plate substrate, a metal layer, and a first metal oxide layer. The metal layer is disposed on the carrier plate substrate, the first metal oxide layer is disposed on a surface of the metal layer away from the carrier plate substrate, and the first metal oxide layer is a metal oxide layer obtained by oxidizing the metal layer.

In some embodiments of the present disclosure, the coating carrier plate for the solar cell further includes a second metal oxide layer. The second metal oxide layer is disposed on a surface of the metal layer away from the first metal oxide layer.

In some embodiments of the present disclosure, a total thickness of the first metal oxide layer, the metal layer, and the second metal oxide layer is 300 nm to 1000 nm.

In some embodiments of the present disclosure, a material of the second metal oxide layer is selected from copper oxide, silver oxide, aluminum oxide, or combinations thereof.

In some embodiments of the present disclosure, the coating carrier plate for the solar cell further includes a first transparent conductive film layer. The first transparent conductive film layer is disposed on a surface of the first metal oxide layer away from the metal layer.

In some embodiments of the present disclosure, a thickness of the first transparent conductive film layer is 300 nm to 800 nm.

In some embodiments of the present disclosure, a material of the first transparent conductive film layer is selected from indium tin oxide, aluminum-doped zinc oxide, or a combination thereof.

In some embodiments of the present disclosure, the material of the first transparent conductive film layer includes indium oxide and tin oxide, and a mass ratio of indium oxide to tin oxide in compositions of the first transparent conductive film layer is (85-95):(5-15).

In some embodiments of the present disclosure, the coating carrier plate for the solar cell further includes a second transparent conductive film layer. The second transparent conductive film layer is disposed between the carrier plate substrate and the metal layer.

In some embodiments of the present disclosure, a thickness of the second transparent conductive film layer is 300 nm to 800 nm.

In some embodiments of the present disclosure, a material of the second transparent conductive film layer is selected from indium tin oxide, aluminum-doped zinc oxide, or a combination thereof.

In some embodiments of the present disclosure, the material of the second transparent conductive film layer includes indium oxide and tin oxide, and a mass ratio of indium oxide to tin oxide in compositions of the second transparent conductive film layer is (96-98):(2-4).

In some embodiments of the present disclosure, a material of the metal layer is selected from copper, silver, aluminum, or combinations thereof, and a material of the first metal oxide layer is selected from copper oxide, silver oxide, aluminum oxide, or combinations thereof.

Furthermore, the present disclosure also provides an application of the coating carrier plate for the solar cell described in the aforementioned embodiments in the preparation of solar cells.

The details of one or more embodiments of the present disclosure are set forth in the accompanying drawings and the description below. Other features, objects and advantages of the present disclosure will become apparent from the description, the accompanying drawings, and the claims.

### BRIEF DESCRIPTION OF THE DRAWINGS

FIG. 1 is a graph showing the relationship between the sheet resistance and the number of use times of the coating carrier plate in Example 1;
FIG. 2 is a graph showing the relationship between the sheet resistance and the number of use times of the coating carrier plate in Comparative Example 1.

### DETAILED DESCRIPTION

In order to facilitate the understanding of the present disclosure, the present disclosure will be more fully described below. Preferable embodiments of the present disclosure are presented herein. However, the present disclosure may be embodied in many different forms and is not limited to the embodiments described herein. Rather, these embodiments are provided so that the understanding of the present disclosure will be more thorough and complete.

All technical and scientific terms used herein have the same meaning as commonly understood by persons skilled in the art to which the present disclosure belongs, unless otherwise defined. The terms used in the specification of the present disclosure herein are for the purpose of describing specific embodiments only and are not intended to limit the present disclosure. As used herein, the term "and/or" includes any and all combinations of one or more of the associated listed items. As used herein, "multiple " includes two and more than two items. As used herein, "above a certain number" should be understood as including the certain number and a range greater than the certain number.

During the coating process, the semi-finished products of heterojunction cells and the carrier plate used to carry and support the heterojunction cells may adsorb a small amount of impurity gases. The moisture content in the impurity gases can significantly affect the properties of the transparent conductive film, including the optoelectronic parameters. In the actual preparation process, the moisture content in the chamber is related to several factors, such as the surrounding atmospheric humidity, the exposure time of the carrier plate to the atmosphere, the pretreatment of the carrier plate, and the pumping time of the feed chamber. These factors exhibit a certain degree of randomness, making the control of the stability of the moisture content extremely complicated. Affected by this, the transparent conductive films exhibit considerable variability in photoelectric parameters and unstable performances, leading to significant fluctuations in the performance of the heterojunction cells finally formed. The inventors have found that the carrier plate absorbs a certain amount of moisture during use, which alters the composition of the transparent conductive films on the heterojunction solar cells and gradually changes the sheet resistance of the solar cells. The inventors have proposed a preparation method of the solar cell to address the above issue.

According to an embodiment of the present disclosure, a preparation method of a solar cell includes the following steps:

providing a coating carrier plate; and placing, on the coating carrier plate, a wafer to be prepared into the solar cell, and depositing a transparent conductive film on a surface of the wafer. A preparation method of the coating carrier plate includes: depositing a metal layer on a carrier plate substrate, and then subjecting the metal layer to an oxidation treatment to form a first metal oxide layer on the metal layer.

In some specific examples of this embodiment, the preparation method further includes: prior to depositing the metal layer, placing the carrier plate substrate into an environment containing an oxidizing substance so that the oxidizing substance is adhered to a surface of the carrier plate substrate, and forming a second metal oxide layer on a surface of the subsequently deposited metal layer adjacent to the carrier plate substrate under an action of the adhered oxidizing substance. It should be understood that by previously adhering the oxidizing substance and then forming the second metal oxide layer, absorption of moisture to the surface of the carrier plate substrate can be further prevented.

In some specific examples of this embodiment, the preparation method of the coating carrier plate further includes: depositing a first transparent conductive film layer on the first metal oxide layer.

In some specific examples of this embodiment, a second transparent conductive film layer is deposited on the carrier plate substrate prior to depositing the metal layer.

It should be understood that in the preparation method of the solar cell, the step of providing the coating carrier plate may include preparing the coating carrier plate according to the aforementioned preparation method, or directly taking the coating carrier plate prepared according to the aforementioned preparation method. The coating carrier plate may be a coating carrier plate that is newly prepared according to the aforementioned preparation method and has not been used, or may be a coating carrier plate that has been used after preparation.

In a specific example, in the preparation method of the coating carrier plate, the carrier plate substrate can be selected from a vapor deposition carrier plate that has been cleaned to remove the surface-adhered material. Further optionally, after cleaning to remove the surface-adhered material, a rough coating is formed on the surface of the vapor deposition carrier plate.

Specifically, the coating carrier plate for the solar cell can be prepared according to the following steps.

Step S1, depositing a first transparent conductive film layer on a carrier plate substrate, and adhering an oxidizing substance to the first transparent conductive film layer.

In a specific example, a material of the first transparent conductive film layer can be selected from indium tin oxide, aluminum-doped zinc oxide, or a combination thereof, and a corresponding target can be selected during deposition. In an embodiment of the present disclosure, the material of the first transparent conductive film layer is selected from indium tin oxide, and a mass ratio of indium oxide to tin oxide is (85-95):(5-15). Furthermore, the method for depositing the first transparent conductive film layer is selected from magnetron sputtering. When depositing the first transparent conductive film layer, a sputtering power is controlled to be 8.5 kW to 13.5 kW, and a deposition temperature is controlled to be 120°C to 150°C.

In a further specific example of the present disclosure, when depositing the first transparent conductive film layer, the target used is an indium tin oxide target, and oxygen is introduced at a flow rate of 50 sccm to 100 sccm during deposition. The introduction of oxygen allows sufficient oxidization of the indium atoms, thereby improving the film crystallinity of the indium tin oxide film layer, which can reduce the oxygen vacancies in the first transparent conductive film layer, thereby preventing water and oxygen from remaining in the first transparent conductive film layer.

In a specific example of the present disclosure, adhering the oxidizing substance to the first transparent conductive film layer includes: placing the carrier plate substrate deposited with the first transparent conductive film layer into a first humid environment to absorb moisture. Specifically, for example, a humidity of the first humid environment is 30% to 50%, and a temperature of the first humid environment is 20°C to 25°C. The time of the placement in the first humid environment can be controlled to be 6h to 12h. This additional step allows the surface of the first transparent conductive film layer to absorb moisture for oxidating the subsequently deposited metal layer.

Step S2, depositing a metal layer on the first transparent conductive film layer, forming a first metal oxide layer on a surface of the metal layer adjacent to the first transparent conductive film layer, and forming a second metal oxide layer on a surface of the metal layer away from the first transparent conductive film layer.

In a specific example, a material of the deposited metal layer can be selected from copper. The method for depositing copper can be selected from magnetron sputtering. In a specific example of the present disclosure, when depositing the metal layer, a sputtering power is controlled to be 8.5 kW to 13.5 kW, and a deposition temperature is controlled to be 120°C to 150°C. In this way, the density of the metal layer deposited from elemental copper can be 1 to 3 times greater that of the transparent conductive film layer of, for example, indium tin oxide.

Since the surface of the first transparent conductive film layer has been adsorbed with the oxidizing material, during the process of depositing the material of the metal layer, the metal material at the surface, which has a relatively high atomic reactivity, can directly react with the oxidizing material to form the first metal oxide layer on the first transparent conductive film layer. The intrastratal metal material further constitutes the dense metal layer.

In a specific example, the step of subjecting the metal layer to the oxidization treatment includes: placing the carrier plate substrate deposited with the metal layer in a second humid environment to absorb moisture, with a humidity of the second humid environment controlled to be 30% to 50%, and a temperature of the second humid environment controlled to be 20°C to 25°C. This step allows the surface of the metal layer to fully contact with moisture, such that the outer surface of the metal layer can easily react with moisture to form the dense second metal oxide layer.

Step S3, depositing a second transparent conductive film layer on the second metal oxide layer.

In a specific example, a material of the second transparent conductive film layer can be selected from indium tin oxide, aluminum-doped zinc oxide, and a combination thereof, and a corresponding target can be selected during deposition. In an embodiment of the present disclosure, the material of the second transparent conductive film layer is selected from indium tin oxide, and a mass ratio of indium oxide to tin oxide is (96-98):(2-4). Furthermore, the method for depositing the second transparent conductive film layer is selected from magnetron sputtering. When depositing the second transparent conductive film layer, a sputtering power is controlled to be 8.5 kW to 13.5 kW, and a deposition temperature is controlled to be 120°C to 150°C.

Optionally, when depositing the second transparent conductive film layer, the target used is an indium tin oxide target, and oxygen is introduced at a flow rate of 50 sccm to 100 sccm during deposition.

The preparation of the coating carrier plate used in the aforementioned embodiments of the present disclosure can be completed by above steps S1 to S3.

After obtaining the coating carrier plate, the wafter to be prepared into the solar cell can be placed on the coating carrier plate, and the coating carrier plate is placed in a deposition chamber of a vapor deposition device to deposit the transparent conductive film on the surface of the wafer. Optionally, the wafer includes a silicon substrate, a first intrinsic amorphous silicon film and a first doped amorphous silicon film that are deposited on a first surface of the silicon substrate, and a second intrinsic amorphous silicon film and a second doped amorphous silicon film that are deposited on a second surface of the silicon substrate opposite to the first surface. The deposited transparent conductive film may be prepared on a surface of the first doped amorphous silicon film and/or the second doped amorphous silicon film.

According to another embodiment of the present disclosure, a coating carrier plate for a solar cell is provided, which includes: a carrier plate substrate, a metal layer, and a first metal oxide layer. The metal layer is disposed on the carrier plate substrate, the first metal oxide layer is disposed on a surface of the metal layer away from the carrier plate substrate, and the first metal oxide layer is a metal oxide layer obtained by oxidizing the metal layer.

In a specific example, the coating carrier plate further includes a second metal oxide layer. The second metal oxide layer is disposed on a surface of the metal layer away from the first metal oxide layer.

In a specific example, the coating carrier plate further includes a first transparent conductive film layer and/or a second transparent conductive film layer. The first transparent conductive film layer is disposed on a surface of the first metal oxide layer away from the metal layer, and the second transparent conductive film layer is disposed between the carrier plate substrate and the metal layer.

In a specific example, metal elements in the first metal oxide layer and the second metal oxide layer are the same as metal elements in the metal layer. For example, when the metal layer is made of copper, the first metal oxide layer and the second metal oxide layer are made of copper oxide.

In a specific example, materials of the first metal oxide layer and the second metal oxide layer are selected from dense metal oxides. Dense metal oxides refer to metal oxides that can block molecules such as moisture and oxygen from passing therethrough. Many metals can form dense metal oxide layers under certain oxidation conditions. For example, aluminum can react with oxygen in the air at room temperature to form a dense aluminum oxide film layer.

Specifically, the first metal oxide layer can be prepared as follows: an oxidizing substance is adhered to the first transparent conductive film layer, and the material of the metal layer is deposited on the first transparent conductive film layer, so that the first metal oxide layer is formed on a side of the metal layer adjacent to the first transparent conductive film layer. A dense metal layer can be prepared on the first transparent conductive film layer by deposition, and then the dense metal layer can be oxidated to form the dense first metal oxide layer.

In a specific example, when preparing the dense first metal oxide layer made of copper oxide, a dense copper layer can be first deposited on the first transparent conductive film layer, and then the dense copper layer is oxidized to form a dense copper oxide layer. The method of oxidizing the dense copper layer includes placing the carrier plate substrate deposited with the dense copper layer in a humid atmosphere for oxidation.

The metal layer, the first metal oxide layer, and the second metal oxide layer mainly play the role of isolating water and oxygen to prevent water and oxygen from being adsorbed on the surface of the carrier plate. In a specific example, in order to improve the isolation effect, a total thickness of the first metal oxide layer, the metal layer, and the second metal oxide layer is 300 nm to 1000 nm. Optionally, the total thickness of the first metal oxide layer, the metal layer, and the second metal oxide layer is 400 nm to 800 nm.

The first transparent conductive film layer mainly plays a role in forming stable adsorption with the dense metal oxide layer, and also preventing the carrier plate itself from absorbing water and oxygen. In a specific example, a thickness of the first transparent conductive film layer is 300 nm to 800 nm. Optionally, the thickness of the first transparent conductive film layer is 400 nm to 600 nm.

The second transparent conductive film mainly plays a role in protecting the dense metal oxide layer from being sputtered onto the cell, and also adding a layer of protection for the carrier plate substrate to prevent the carrier plate from absorbing water and oxygen. In a specific example, a thickness of the second transparent conductive film layer is 300 nm to 800 nm. Optionally, the thickness of the second transparent conductive film layer is 400 nm to 600 nm.

The materials of the first transparent conductive film layer and the second transparent conductive film layer may be the same as the materials of the corresponding transparent conductive film prepared on the solar cell. For example, when the coating carrier plate is used in the preparation of a solar cell using a transparent conductive film of indium tin oxide, the first transparent conductive film layer and/or the second transparent conductive film layer of the coating carrier plate can be made of indium tin oxide correspondingly. In a specific example, the first transparent conductive film layer is selected from indium tin oxide, aluminum-doped zinc oxide or a combination thereof. In a specific example, the second transparent conductive film layer is selected from indium tin oxide, aluminum-doped zinc oxide or a combination thereof.

In a specific example, the first transparent conductive film layer and the second transparent conductive film layer are both selected from indium tin oxide. Furthermore, in composition of the first transparent conductive film layer, a mass ratio of indium oxide to tin oxide is (85-95):(5-15). Optionally, in composition of the first transparent conductive film layer, the mass ratio of indium oxide to tin oxide is (88-92):(8~12). For example, the mass ratio of indium oxide to tin oxide is 90: 10. In composition of the second transparent conductive film layer, a mass ratio of indium oxide to tin oxide is (96-98):(2-4). Optionally, the mass ratio of indium oxide to tin oxide is 97:3.

In another aspect, the present disclosure further provides an application of the coating carrier plate for the solar cell described in any one of the aforementioned embodiments in the preparation of solar cells.

By providing the first transparent conductive film layer, the first metal oxide layer, the metal layer, the second metal oxide layer, and the second transparent conductive film layer, the coating carrier plate for the solar cell can effectively reduce the influence of environmental factors, such that the sensitivity of the carrier plate to environmental changes is reduced, which in turn reduces the time required for the surface sheet resistance of the solar cell to stabilize during the production process, thereby improving the stability of product quality. It has been proved by experiments that compared with coating carrier plates for solar cells in the prior art, the aforementioned coating carrier plate for the solar cell can achieve the following beneficial effects: after being put into use, the coating carrier plate for the solar cell can make the initial surface sheet resistance of the produced solar cell lower and reach the stable value more quickly, ensuring the stable product quality of the produced solar cell. Furthermore, since the sensitivity of the coating carrier plate to environmental changes is reduced, the pretreatment time of the coating carrier plate can be shortened to about 30 seconds when entering the feed chamber, which is conducive to improving the production takt and further improving the production capacity of the equipment.

In order to facilitate understanding and implementation of the present disclosure, the following examples which are easier to implement and more specific and comparative examples are provided as references. The various embodiments of the present disclosure and their advantages will be apparent from the description and performance results of the following specific examples and comparative examples.

Unless otherwise specified, the raw materials used in the following examples are commonly available from the market.

### Example 1

A cleaned physical vapor deposition carrier plate was used as the carrier plate substrate, and the carrier plate substrate has been coated with a rough coating.

Deposition of a first transparent conductive film layer: the carrier plate substrate was placed in a magnetron sputtering deposition chamber, and an indium tin oxide target (ITO target) with a mass ratio of indium oxide to tin oxide of 90: 10 was selected. A sputtering power was set to 10 kW, a deposition temperature was set to 130°C, and argon-hydrogen mixed gas at 1000 sccm and oxygen gas at 60 sccm were introduced as a deposition atmosphere. The deposition time was controlled such that a thickness of the first transparent conductive film layer was 500 nm.

First moisture adsorption: the carrier plate substrate deposited with the first transparent conductive film layer was placed in a workshop environment at a humidity of 40% and a temperature of 25°C for 8 hours.

Deposition of dense copper metal: after the first moisture adsorption, elemental copper was selected as the target, and metallic copper was deposited by magnetron sputtering. A sputtering power was 8.5kW, a deposition temperature was 130°C, and argon-hydrogen mixed gas at 1000 sccm was introduced. A thickness of the deposited copper metal layer was 1000 nm.

Second moisture adsorption: the carrier plate substrate deposited with the copper metal layer was placed in a workshop environment at a humidity of 40% and a temperature of 25°C for 8 hours.

Deposition of a second transparent conductive film layer: the carrier plate substrate was placed in a magnetron sputtering deposition chamber, and an indium tin oxide target (ITO target) with a mass ratio of indium oxide to tin oxide of 97:3was selected. A sputtering power was set to 10 kW, a deposition temperature was set to 130°C, and argon-hydrogen mixed gas at 1000 sccm and oxygen gas at 80 sccm were introduced as a deposition atmosphere. A deposition time was controlled such that a thickness of the second transparent conductive film layer was 800 nm.

### Example 2

A cleaned physical vapor deposition carrier plate was used as the carrier plate substrate, and the carrier plate substrate has been coated with a rough coating.

Deposition of a first transparent conductive film layer: the carrier plate substrate was placed in a magnetron sputtering deposition chamber, and an indium tin oxide target (ITO target) with a mass ratio of indium oxide to tin oxide of 90: 10 was selected. A sputtering power was set to 10 kW, a deposition temperature was set to 130°C, and argon-hydrogen mixed gas at 1000 sccm was introduced as a deposition atmosphere. A deposition time was controlled such that a thickness of the first transparent conductive film layer was 500 nm.

First moisture adsorption: the carrier plate substrate deposited with the first transparent conductive film layer was placed in a workshop environment at a humidity of 40% and a temperature of 25°C for 8 hours.

Deposition of dense copper metal: after the first moisture adsorption, elemental copper was selected as the target, and metallic copper was deposited by magnetron sputtering. A sputtering power was 8.5kW, a deposition temperature was 130°C, and argon-hydrogen mixed gas at 1000 sccm was introduced. A thickness of the deposited copper metal layer was 1000 nm.

Second moisture adsorption: the carrier plate substrate deposited with the copper metal layer was placed in a workshop environment at a humidity of 40% and a temperature of 25°C for 8 hours.

Deposition of a second transparent conductive film layer: the carrier plate substrate was placed in a magnetron sputtering deposition chamber, and an indium tin oxide target (ITO target) with a mass ratio of indium oxide to tin oxide of 97:3was selected. A sputtering power was set to 10 kW, a deposition temperature was set to 130°C, and argon-hydrogen mixed gas at 1000 sccm was introduced as a deposition atmosphere. A deposition time was controlled such that a thickness of the second transparent conductive film layer was 800 nm.

### Comparative Example 1

A cleaned physical vapor deposition carrier plate was used as the carrier plate substrate, and the carrier plate substrate has been coated with a rough coating.

Deposition of a transparent conductive film layer: the carrier plate substrate was placed in a magnetron sputtering deposition chamber, and an indium tin oxide target (ITO target) with a mass ratio of indium oxide to tin oxide of 90:10was selected. A sputtering power was set to 10 kW, a deposition temperature was set to 130°C, and argon-hydrogen mixed gas at 1000 sccm and oxygen gas at 60 sccm were introduced as a deposition atmosphere. A deposition time was controlled such that a thickness of the transparent conductive film layer was 1300 nm.

### Comparative Example 2

A cleaned physical vapor deposition carrier plate was used as the carrier plate substrate, and the carrier plate substrate has been coated with a rough coating.

Deposition of a first transparent conductive film layer: the carrier plate substrate was placed in a magnetron sputtering deposition chamber, and an indium tin oxide target (ITO target) with a mass ratio of indium oxide to tin oxide of 90: 10 was selected. A sputtering power was set to 10 kW, a deposition temperature was set to 130°C, and argon-hydrogen mixed gas at 1000 sccm and oxygen gas at 60 sccm were introduced as a deposition atmosphere. A deposition time was controlled such that a thickness of the first transparent conductive film layer was 500 nm.

Deposition of a second transparent conductive film layer: the carrier plate substrate was placed in a magnetron sputtering deposition chamber, and an indium tin oxide target (ITO target) with a mass ratio of indium oxide to tin oxide of 97:3was selected. A sputtering power was set to 10 kW, a deposition temperature was set to 130°C, and argon-hydrogen mixed gas at 1000 sccm and oxygen gas at 800 sccm were introduced as a deposition atmosphere. A deposition time was controlled such that a thickness of the second transparent conductive film layer was 800 nm.

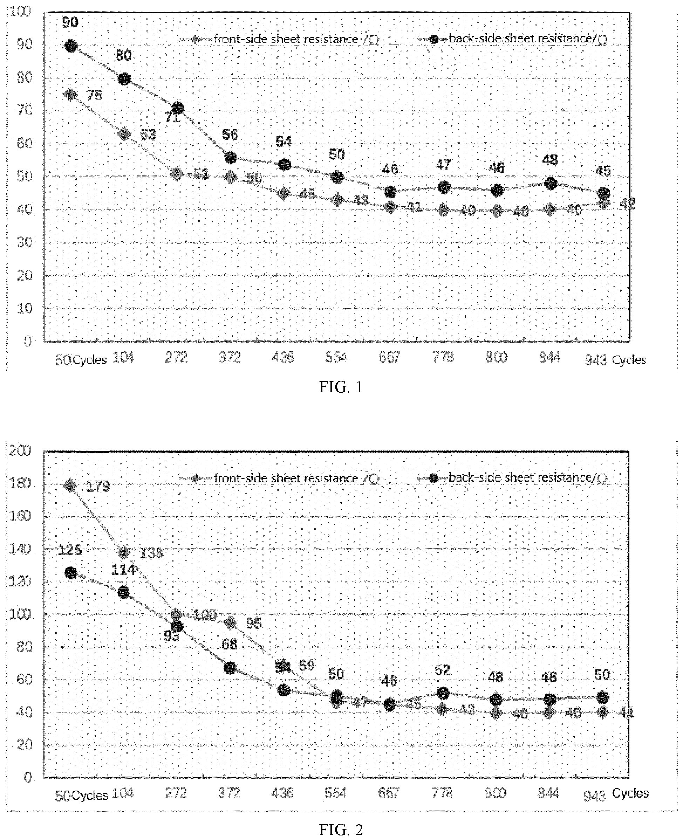

Test Example: The carrier plates of Examples 1 to 2 and Comparative Examples 1 to 2 were put into a production line of heterojunction solar cells to support semi-finished products of the solar cells during deposition of the transparent conductive film. The transparent conductive film of the heterojunction solar cell was made of indium tin oxide, and a mass ratio of indium oxide to tin oxide in the transparent conductive film on the front-side was 90: 10, and a mass ratio of indium oxide to tin oxide in the transparent conductive film on the back-side was 97:3. The number of use times of individual coating carrier plates and the corresponding front-side and back-side sheet resistances of the solar cell were recorded. The front-side and back-side sheet resistances of the solar cell at the initial stage (when the coating carrier plate had been used 50 times) and the number of use times of the coating carrier plates when the sheet resistances are basically stable are recorded in Table 1. The variation trends of the sheet resistances of Example 1 and Comparative Example 1 with the number of use times of the coating carrier plates can be seen in FIGS. 1 and 2, respectively.

**Table 1**

| | Initial front-side sheet resistance/Ω | Initial back-side sheet resistance/Ω | Number of use times of the carrier plate when the sheet resistance was stable |
|---|---|---|---|
| Example 1 | 75 | 90 | 372 |
| Example 2 | 130 | 100 | 455 |
| Comparative Example 1 | 179 | 126 | 554 |
| Comparative Example 2 | 185 | 130 | 560 |

Referring to Table 1 and FIGS. 1 and 2 , it can be clearly seen from Example 1 and Comparative Example 1 that the initial front-side sheet resistance of Example 1 is only 75 Ω and the back-side sheet resistance of Example 1 is only 90 Ω, which are much lower than 179 Ω and 126 Ω of Comparative Example 1, respectively, indicating that the coating carrier plate provided by the present disclosure can significantly reduce the initial sheet resistance of solar cells. At the same time, for Example 1, the sheet resistance of the solar cell basically reached a stable value after the coating carrier plate was used for about 372 times, while for Comparative Example 1, the sheet resistance of the solar cell basically reached a stable value after being used for about 554 times, indicating that the coating carrier plate provided by the present disclosure can also reduce the time required for the surface sheet resistance of the solar cell to stabilize during production.

The technical features of the aforementioned embodiments can be combined arbitrarily. To simplify the description, not all the possible combinations of the technical features in the aforementioned embodiments are described. However, all of the combinations of these technical features should be considered as within the scope of the present disclosure, as long as such combinations do not contradict with each other.

The aforementioned embodiments merely illustrate several embodiments of the present disclosure, and the description thereof is specific and detailed, but it shall not be constructed as limiting the scope of the present disclosure. It should be noted that, for those ordinary skilled in the art, several variations and improvements can be made without departing from the concept of the present disclosure, which are all within the protection scope of the present disclosure. Therefore, the protection scope of the present disclosure shall be defined by the appended claims.

## Claims

1. A preparation method of a solar cell, comprising the following steps:
providing a coating carrier plate; and
placing, on the coating carrier plate, a wafter to be prepared into the solar cell, and depositing a transparent conductive film on a surface of the wafer;
wherein a preparation method of the coating carrier plate comprises:
depositing a metal layer on a carrier plate substrate, and then subjecting the metal layer to an oxidation treatment to form a first metal oxide layer on the metal layer.

2. The preparation method of the solar cell according to claim 1, wherein the step of subjecting the metal layer to the oxidation treatment comprises: placing the carrier plate substrate deposited with the metal layer in a first humid environment to absorb moisture and oxidize the metal layer by the moisture.

3. The preparation method of the solar cell according to claim 2, wherein a humidity of the first humid environment is controlled to be 30% to 50%, and a temperature of the first humid environment is controlled to be 20°C to 25°C.

4. The preparation method of the solar cell according to claim 1, further comprising: prior to the depositing the metal layer, placing the carrier plate substrate in an environment containing an oxidizing substance to adhere the oxidizing substance to a surface of the carrier plate substrate, and forming a second metal oxide layer on a surface of the subsequently deposited metal layer adjacent to the carrier plate substrate under an action of the adhered oxidizing substance.

5. The preparation method of the solar cell according to claim 4, wherein the placing the carrier plate substrate in the environment containing the oxidizing substance comprises: placing the carrier plate substrate in a second humid environment to absorb moisture as the oxidizing substance.

6. The preparation method of the solar cell according to claim 5, wherein a humidity of the second humid environment is controlled to be 30% to 50%, and a temperature of the second humid environment is controlled to be 20°C to 25°C.

7. The preparation method of the solar cell according to claim 5, wherein the carrier plate substrate is placed in the second humid environment for a time of 6 hours to 12 hours.

8. The preparation method of the solar cell according to any one of claims 1 to 7, wherein the preparation method of the coating carrier plate further comprises: depositing a first transparent conductive film layer on the first metal oxide layer.

9. The preparation method of the solar cell according to claim 8, wherein when depositing the first transparent conductive film layer, an indium tin oxide target is used as a target, and oxygen is introduced at a flow rate of 50 sccm to 100 sccm during deposition.

10. The preparation method of the solar cell according to any one of claims 1 to 9, wherein the preparation method of the coating carrier plate further comprises: depositing a second transparent conductive film layer on the carrier plate substrate prior to depositing the metal layer.

11. The preparation method of the solar cell according to claim 10, wherein when depositing the second transparent conductive film layer, an indium tin oxide target is used as a target, and oxygen is introduced at a flow rate of 50 sccm to 100 sccm during deposition.

12. The preparation method of the solar cell according to any one of claims 1 to 11, wherein the metal layer is deposited by magnetron sputtering, and when depositing the metal layer, a sputtering power is controlled to be 8.5 kW to 13.5 kW, and a deposition temperature is controlled to be 120°C to 150°C.

13. A coating carrier plate for a solar cell, comprising: a carrier plate substrate, a metal layer, and a first metal oxide layer, wherein the metal layer is disposed on the carrier plate substrate, the first metal oxide layer is disposed on a surface of the metal layer away from the carrier plate substrate, and the first metal oxide layer is a metal oxide layer obtained by oxidating the metal layer.

14. The coating carrier plate for the solar cell according to claim 13, further comprising a second metal oxide layer, wherein the second metal oxide layer is disposed on a surface of the metal layer away from the first metal oxide layer.

15. The coating carrier plate for the solar cell according to claim 14, wherein a total thickness of the first metal oxide layer, the metal layer, and the second metal oxide layer is 300 nm to 1000 nm.

16. The coating carrier plate for the solar cell according to any one of claims 14 to 15, wherein a material of the second metal oxide layer is selected from copper oxide, silver oxide, aluminum oxide, or combinations thereof.

17. The coating carrier plate for the solar cell according to any one of claims 13 to 16, further comprising a first transparent conductive film layer, wherein the first transparent conductive film layer is disposed on a surface of the first metal oxide layer away from the metal layer.

18. The coating carrier plate for the solar cell according to claim 17, wherein a thickness of the first transparent conductive film layer is 300 nm to 800 nm.

19. The coating carrier plate for the solar cell according to claim 17, wherein a material of the first transparent conductive film layer is selected from indium tin oxide, aluminum-doped zinc oxide, or a combination thereof.

20. The coating carrier plate for the solar cell according to claim 17, wherein a material of the first transparent conductive film layer comprises indium oxide and tin oxide, and a mass ratio of indium oxide to tin oxide in composition of the first transparent conductive film layer is (85-95):(5-15).

21. The coating carrier plate for the solar cell according to any one of claims 13 to 20, further comprising a second transparent conductive film layer, wherein the second transparent conductive film layer is disposed between the carrier plate substrate and the metal layer.

22. The coating carrier plate for the solar cell according to claim 21, wherein a thickness of the second transparent conductive film layer is 300 nm to 800 nm.

23. The coating carrier plate for the solar cell according to claim 21, wherein a material of the second transparent conductive film layer is selected from indium tin oxide, aluminum-doped zinc oxide, or a combination thereof.

24. The coating carrier plate for the solar cell according to claim 21, wherein a material of the second transparent conductive film layer comprises indium oxide and tin oxide, and a mass ratio of indium oxide to tin oxide in composition of the second transparent conductive film layer is (96-98):(2-4).

25. The coating carrier plate for the solar cell according to any one of claims 13 to 24, wherein a material of the metal layer is selected from copper, silver, aluminum, or combinations thereof, and a material of the first metal oxide layer is selected from copper oxide, silver oxide, aluminum oxide, or combinations thereof.

26. Application of the coating carrier plate for the solar cell according to any one of claims 13 to 25 in the preparation of solar cells.
